# EUROPÄISCHE PATENTANMELDUNG

(11) **EP 2 172 578 A1**
(43) Veröffentlichungstag der Anmeldung: **07.04.2010**
(21) Anmeldenummer: 09010367.2
(22) Anmeldetag: 12.08.2009
(51) Int. Cl.: C23C 14/08, C23C 14/06, C23C 14/56, C23C 14/35, C23C 16/44, C23C 14/22

(54) **Vorrichtung und Verfahren zum Abscheiden einer Gradientenschicht**

(30) Priorität: 01.10.2008 DE 102008050196
(71) Anmelder: Fraunhofer-Gesellschaft zur Förderung der angewandten Forschung e.V., 80686 München (DE)
(72) Erfinder: Meyer, Björn, 01159 Dresden (DE); Fahland, Matthias, 01259 Dresden (DE); Günther, Steffen, 01309 Dresden (DE)
(74) Vertreter: Ostermann, Dirk

(57) **Zusammenfassung**

Die Erfindung betrifft eine Vorrichtung und ein Verfahren zum Abscheiden einer Schicht auf einem innerhalb einer Vakuumkammer (12) bewegten Substrat (11), wobei zumindest ein Schichtelement einen Gradienten im Schichtdickenverlauf aufweist, wobei das Schichtelement als Bestandteil eines Monomers durch einen ersten Einlass (16) in die Vakuumkammer (12) eingelassen wird und mittels mindestens eines Magnetrons (14a) ein Plasma (15) erzeugt wird, welches das Monomer aktiviert und eine chemische Schichtabscheidung auf dem Substrat (11) bewirkt und wobei der erste Einlass (16) in Bewegungsrichtung des Substrates (11) betrachtet vor oder nach dem Magnetron (14a) angeordnet wird.

## Beschreibung

Die Erfindung betrifft eine Vorrichtung und ein Verfahren zum Abscheiden einer Gradientenschicht, bei welcher der prozentuale Anteil zumindest eines Schichtelements einen Gradienten im Schichtdickenverlauf aufweist. Insbesondere betrifft die Erfindung diejenigen Vorrichtungen und Verfahren der chemischen Dampfabscheidung, bei denen ein zu beschichtendes Substrat während des Beschichtens durch eine Beschichtungszone geführt wird und bei denen das im Schichtdickenverlauf mit einem Konzentrationsgradienten behaftete Schichtelement als Bestandteil eines Monomers in eine Vakuumkammer eingelassen wird.

Zum Schutz eines Kunststoffsubstrates wird auf dessen Oberfläche oftmals eine Kratzschutzschicht abgeschieden. Gegenüber einem relativ weichen Kunststoffsubstrat weist eine Kratzschutzschicht an dessen Oberfläche üblicherweise eine höhere Härte auf, um die Kratzschutzeigenschaften zu erfüllen. Es ist bekannt, den Übergang vom relativ weichen Substrat zur harten Schichtoberfläche als Gradientenschicht auszubilden, um einerseits gute Hafteigenschaften der Kratzschutzschicht auf dem Substrat zu erlangen und andererseits die guten Kratzschutzeigenschaften auf der Schichtoberfläche beizubehalten. Neben Kratzschutzschichten werden aber auch andere Schichtarten wie beispielsweise Glättungsschichten als Gradientenschichten auf einem Kunststoffsubstrat abgeschieden.

Es ist bekannt, derartige Gradientenschichten mittels sogenannter CVD-(chemical vapor deposition)-Verfahren abzuscheiden, bei denen der Abscheideprozess auf einer chemischen Reaktion beruht. Dabei kann die chemische Reaktion innerhalb einer Vakuumkammer aufgrund der Anwesenheit eines Plasmas angeregt werden. Derartige Verfahren werden als PCVD (plasma chemical vapor deposition) oder auch PECVD (plasma enhanced chemical vapor deposition) bezeichnet. Beim PCVD zum Abscheiden von Gradientenschichten wird ein Plasma üblicherweise entweder mittels einer Mikrowellen-Quelle oder einer Hochfrequenz-(HF)-Quelle, die auch als Radio-Frequency-(RF)-Quelle bezeichnet sein kann, erzeugt.

DE 44 45 427 C2 beschreibt ein Plasma-CVD-Verfahren, bei dem eine Gradientenschicht abgeschieden wird, indem der Schichtgradient über das Verändern von Pulsparametern einer gepulst betriebenen Plasmaquelle eingestellt wird. Weiterhin ist es auch bekannt, die Gaszuflüsse in eine Vakuumkammer zu verändern, um bei einem CVD-Verfahren eine Gradientenschicht abzuscheiden. Beiden Verfahren haftet der Nachteil an, dass diese nur bei stationär zur beschichtenden Substraten angewendet werden können, bei einer Rolle-zu-Rolle-Beschichtung am bewegten Substrat sind diese hingegen nicht geeignet.

Eine weitere bekannte Möglichkeit zum Abscheiden einer Gradientenschicht bei CVD-Verfahren besteht darin, die Bewegungsrichtung eines durch eine Beschichtungszone geführten Substrates einzustellen (DE 103 23 453 B4).

Allen bekannten Verfahren ist gemein, dass diese über separate Mittel bzw. Regelkreise verfügen müssen, mittels denen entweder elektrische Parameter, Gaszuflussmengen in die Vakuumkammer oder die Bewegungsrichtung eines Substrates eingestellt werden, um eine Gradientenschicht abzuscheiden.

### Aufgabenstellung

Der Erfindung liegt daher das technische Problem zugrunde, eine Vorrichtung und ein Verfahren zum Abscheiden von Gradientenschichten auf Basis chemischer Reaktionen zu schaffen, mittels denen die Nachteile aus dem Stand der Technik überwunden werden können. Insbesondere sollen erfindungsgemäße Vorrichtungen und Verfahren mit einfachen technischen Mitteln ausführbar und bei einer Rolle-zu-Rolle-Beschichtung am bewegten Substrat anwendbar sein. Bei der Schichtabscheidung soll das Substrat einer möglichst geringen thermischen Belastung ausgesetzt sein.

Die Lösung des technischen Problems ergibt sich durch die Gegenstände mit den Merkmalen der Patentansprüche 1 und 9. Weitere vorteilhafte Ausgestaltungen der Erfindung ergeben sich aus den abhängigen Patentansprüchen.

Erfindungsgemäße Vorrichtungen und Verfahren zum Abscheiden einer Schicht auf einem innerhalb einer Vakuumkammer bewegten Substrat, wobei zumindest ein Schichtelement einen Gradienten im Schichtdickenverlauf aufweist, zeichnen sich dadurch aus, dass das Schichtelement als Bestandteil eines Monomers durch einen ersten Einlass in die Vakuumkammer eingelassen wird und dass mittels mindestens eines Magnetrons ein Plasma erzeugt wird, welches das Monomer aktiviert und eine chemische Schichtabscheidung auf dem Substrat bewirkt und wobei der erste Einlass in Bewegungsrichtung des Substrates betrachtet vor oder nach dem Magnetron angeordnet wird.

Da der Begriff Magnetron auch im Zusammenhang mit Einrichtungen zum Erzeugen von Mikrowellen verwendet wird, sei an dieser Stelle darauf verwiesen, dass der Begriff "Magnetron" im erfindungsgemäßen Sinne derartige Einrichtungen bezeichnet, die üblicherweise zum Sputtern verwendet werden.

Durch das in Bewegungsrichtung eines zu beschichtenden Substrates asymmetrische Anordnen des Einlasses für das Monomer, entweder vor oder nach dem Magnetron, wird ein Konzentrationsgefälle des Monomers in Bewegungsrichtung des Substrates in der Beschichtungszone (also im Bereich zwischen dem Magnetron und dem Substrat) ausgebildet. Dabei ist der Konzentrationsgehalt des Monomers in unmittelbarer Umgebung des Monomer-Einlasses am höchsten und wird mit zunehmendem Abstand vom Einlass immer geringer.

Monomerpartikel, die sich im Wirkbereich des durch das Magnetron erzeugten Plasmas befinden, werden durch das Plasma aktiviert, aufgespalten und zur chemischen Schichtabscheidung angeregt. In dem Bereich der Beschichtungszone, also zwischen dem Magnetron und dem Substrat, in welchem die höchste Konzentration an Monomerpartikeln vorherrscht, werden folgerichtig auch die meisten Monomerbestandteile durch die Einwirkung des Plasmas aufgespalten und zur chemischen Schichtabscheidung angeregt.

Befindet sich der Monomer-Einlass in Bewegungsrichtung des Substrates beispielsweise vor dem Magnetron, ist folgerichtig der Schichtzuwachs auf dem Substrat, herrührend aus chemischer Schichtabscheidung, beim Durchqueren der Beschichtungszone zu Beginn am größten und nimmt beim weiteren Durchqueren der Beschichtungszone kontinuierlich ab. Obwohl der Schichtzuwachs beim Durchqueren der Beschichtungszone kontinuierlich abnimmt, wäre aber dennoch davon auszugehen, dass das Konzentrationsverhältnis der am Schichtaufbau beteiligten Schichtelemente während des Schichtwachstums konstant bleibt.

Überraschend konnte jedoch festgestellt werden, dass bei einer in Bewegungsrichtung des Substrates asymmetrischen Anordnung des Monomer-Einlasses die Konzentration zumindest einiger am Schichtaufbau beteiligter Elemente einen Konzentrationsgradienten in Richtung Schichtdicke aufweisen. So werden beispielsweise in dem Bereich, in dem zwischen dem Magnetron und dem Substrat die größte Monomermenge vorherrscht (also in unmittelbare Nähe des Monomer-Einlasses) auch die höchsten prozentualen Schichtanteile der Elemente Kohlenstoff und Wasserstoff abgeschieden.

Befindet sich der Monomer-Einlass also in Bewegungsrichtung des Substrates vor dem Magnetron, so weist die auf dem Substrat abgeschiedene Schicht unmittelbar am Substrat den höchsten prozentualen Anteil an Kohlenstoff und Wasserstoff auf. Die prozentualen Schichtanteile der Elemente Kohlenstoff und Wasserstoff nehmen dann zur Schichtoberfläche hin ab und weisen an der Schichtoberfläche die geringsten Konzentrationen auf. Umgekehrt verhält es sich, wenn der Monomer-Einlass in Bewegungsrichtung des Substrates hinter dem Magnetron angeordnet ist. Dann weist die abgeschiedene Schicht in Substratnähe die geringsten Konzentrationen von Kohlenstoff und Wasserstoff auf und an der Schichtoberfläche die höchsten.

Eine vollständige Erklärung dieses Effekts wurde noch nicht gefunden. Ein Ansatz lässt sich vielleicht aus dem Sachverhalt ableiten, dass durch die Einwirkung des Magnetron-Plasmas auf die Monomerpartikel und die sich daran anschließenden chemischen Reaktionen Verbindungen mit unterschiedlichem Sticking-Koeffizienten entstehen. Der Sticking-Koeffizient ist ein Maß für die Reaktions- bzw. Haftungsfähigkeit einer Spezies an einer Oberfläche. So entstehen durch die Plasmaeinwirkung beispielsweise auch Verbindungen wie Kohlendioxid und Wasserdampf, die beide einen geringen Sticking-Koeffizienten aufweisen, sich also sehr schlecht an der Targetoberfläche des Magnetrons oder anderen Vakuumkammerbestandteilen ablagern. Entstehendes Kohlendioxid und Wasserdampf werden daher mittels Vakuumpumpen, die das Vakuum in einer Vakuumkammer aufrechterhalten, aus der Vakuumkammer abgepumpt.

Die vom Magnetron bereitgestellte Energie wirkt über die Targetoberfläche in Bewegungsrichtung des Substrates betrachtet auf Grund der asymmetrischen Anordnung des Monomereinlasses auf eine unterschiedliche Menge von Monomerpartikeln ein. In Nähe des Monomer-Einlasses wirkt diese Energie auf relativ viele Monomerpartikel und mit zunehmendem Abstand vom Einlass auf immer weniger Monomerpartikel. Es wird daher vermutet, dass in den Bereichen, in denen die Magnetronenergie auf relativ viele Monomerpartikel einwirkt, ein anderes Verhältnis von Reaktionsprodukten entsteht als in den Bereichen, in denen die Magnetronenergie nur auf relativ wenige Monomerpartilel einwirkt. So wird weiterhin vermutet, dass in den Bereichen, in denen die Magnetronenergie auf weniger Monomerpartikel einwirkt, prozentual mehr Verbindungen mit geringem Sticking-Koeffizienten wie Kohlendioxid und Wasserdampf gebildet und von den Vakuumpumpen der Kammer abgepumpt werden. Dadurch werden den Bereichen der Beschichtungszone, in denen die Konzentration von Monomerpartikeln am geringsten ist, verhältnismäßig viele Kohlenstoff- und Wasserstoffpartikel entzogen und stehen somit nicht mehr für die Schichtabscheidung zur Verfügung.

Bei anderen Elementen aus einem Monomer wie beispielsweise Silizium ist im Schichtdickenverlauf zwar auch ein Konzentrationsgradient erkennbar, jedoch keiner in fast ausschließlich nur eine Richtung, wie beispielsweise bei Kohlenstoff und Wasserstoff. Bei der Einwirkung des Magnetron-Plasmas auf die Monomerpartikel eines siliziumhaltigen Monomers entstehen überwiegend Siliziumverbindungen, wie zum Beispiel Siliziumoxid, die einen hohen Sticking-Koeffizienten aufweisen, sich beispielsweise auch an der Targetoberfläche ablagern und daher auch nicht durch die Vakuumpumpen der Kammer abgepumpt werden.

Der Anteil von Kohlenstoff innerhalb einer Schicht hat bekanntlich auch einen Einfluss auf die Härte der Schicht im Schichtdickenverlauf. Daher lassen sich mit erfindungsgemäßen Vorrichtungen und Verfahren aufgrund des erzeugten Gradienten bezüglich des Kohlenstoffanteils auch vorteilhaft Schichten mit einem Härtegradienten im Schichtdickenverlauf herstellen.

Bei erfindungsgemäßen Verfahren und Vorrichtungen sind keine Regelkreise erforderlich, mit denen Pulsparameter beim Speisen des Magnetrons oder Gaszuflüsse in die Vakuumkammer gesteuert werden müssen. Auch lassen sich erfindungsgemäß Gradientenschichten sowohl auf Kunststoffsubstraten als auch anderen Materialien abscheiden.

Da der Konzentrationsgradient von Kohlenstoff und Wasserstoff in der abgeschiedenen Schicht in erster Linie vom Konzentrationsgradienten der Monomerpartikel in der Beschichtungszone abhängt, ist es vorteilhaft, wenn sich der in Bewegungsrichtung vor oder nach dem Magnetron angeordnete Einlass für das Monomer in unmittelbarer Nähe des Magnetrons befindet. Der Monomer-Einlass kann beispielsweise mit einem Maß von 10 mm bis 50 mm Magnetron beabstandet sein.

Bei einer Ausführungsform ist das Magnetron als Planar- oder Rohrmagnetron ausgebildet. Vorteilhaft wird solch ein Planar- oder Rohrmagnetron quer zur Bewegungsrichtung des Substrates ausgerichtet.

Bei asymmetrischem Einlass des Monomers ist der Effekt des Ausbildens einer Gradientenschicht zwar schon bei der Verwendung nur eines Magnetrons erkennbar, kommt aber noch wirksamer zum Tragen, wenn mindestens zwei Magnetrons verwendet werden.

Bei einer Ausführungsform werden daher ein erstes Magnetron und ein zweites Magnetron derart ausgerichtet, dass zumindest ein Oberflächenbereich des zum ersten Magnetron gehörenden Targets und ein Oberflächenbereich des zum zweiten Magnetron gehörenden Targets in Bewegungsrichtung des Substrates betrachtet hintereinander angeordnet sind und dabei ist der erste Einlass für das Monomer in Bewegungsrichtung des Substrates betrachtet vor oder nach den beiden Oberflächenbereichen der zwei Targets angeordnet.

Werden zwei oder mehr Magnetrons verwendet, so können ebenfalls längserstreckte Planar- oder Rohrmagnetrons verwendet werden. Eine erfindungsgemäße Vorrichtung kann jedoch auch ein kreisförmiges Doppelmagnetron umfassen. Bei derartigen Doppelmagnetrons sind solche mit ringförmigem Außentarget und scheibenförmigem Innentarget und solche mit ringförmigem Außen- und Innentarget bekannt. Weist das Doppelmagnetron ein ringförmiges Außen- und Innentarget auf, dann kann der Monomer-Einlass nicht nur vor und nach dem Doppelmagnetron sondern auch in der Ringöffnung des Doppelmagnetrons angeordnet sein.

Zum Speisen der Magnetrons sind alle aus dem Stand der Technik bekannten Stromversorgungseinrichtungen anwendbar. Besonders geeignet sind dabei pulsende Stromversorgungseinrichtungen. So kann beispielsweise mindestens ein Magnetron mit einer unipolar pulsenden oder bipolar pulsenden Stromversorgungseinrichtung elektrisch verbunden sein.

Neben dem Monomer können auch noch weitere Bestandteile in die Vakuumkammer eingelassen werden. So kann beispielsweise durch einen zweiten Einlass ein Reaktivgas und/oder durch einen dritten Einlass ein Inertgas in die Vakuumkammer eingelassen werden.

Vordergründig wird das Magnetron (bzw. werden die Magnetrons) innerhalb der Vakuumkammer zum Erzeugen eines Plasmas verwendet, welches die Monomerpartikel aktiviert und zur chemischen Schichtabscheidung anregt. Beim Einwirken eines Magnetron-Plasmas auf ein Monomer entsteht gewöhnlich eine Schicht, die sowohl organische als auch anorganische Verbindungen aufweist. Mittels des Magnetrons können jedoch auch Partikel von den zugehörigen Targets durch Sputtern abgestäubt und auf diese Weise Schichtbestandteile werden.

Bei einem Ausführungsbeispiel sind die Einlassmengen des Monomers und anderer Gase in die Vakuumkammer sowie die Leistungen zweier verwendeter Magnetrons derart aufeinander abgestimmt, dass die Oberflächen der zu den Magnetrons gehörenden Metalltargets während der Schichtabscheidung durchgehend und vollständig mit Oxidpartikeln und/oder Monomerbestandteilen bedeckt sind. In solch einem Fall tragen fast ausschließlich chemische Reaktionen zur Schichtabscheidung bei und die Schicht weist auch keine metallischen Partikel auf.

Sind jedoch die Einlassmengen des Monomers und anderer Gase und/oder die Leistungen der Magnetrons derart aufeinander abgestimmt, dass die Targetoberflächen der Magnetrons während der Schichtabscheidung nicht vollständig mit Oxidpartikeln und/oder Monomerbestandteilen bedeckt sind, dann können auch durch Sputtern von einem Target abgestäubte Metallpartikel zur Schichtabscheidung beitragen.

Der Vollständigkeit halber sei erwähnt, dass das Erhöhen der Einlassmengen des Monomers und von Reaktivgasen in die Vakuumkammer sowie das Verringern der Magnetronleistung als auch den Bedeckungsgrad der Targetoberflächen mit Oxidpartikeln bzw. Monomerbestandteilen erhöht.

Bei einem weiteren Ausführungsbeispiel befindet sich der Monomer-Einlass vor zwei Planarmagnetrons, die jeweils mit einem Metalltarget bestückt und quer zur Bewegungsrichtung eines zu beschichtenden Substrates angeordnet sind. Die Einlassmengen eines Monomers und des Reaktivgases Sauerstoff in eine Vakuumkammer und die Leistungen der Magnetrons sind derart eingestellt, dass die in Bewegungsrichtung des Substrates hinteren Oberflächenbereiche des zweiten Targets während der Beschichtung nicht mit Oxidpartikeln und Monomerbestandteilen bedeckt sind. Die abgeschiedene Schicht weist daher an der Schichtoberfläche eine Teilschicht mit metallischem Anteil auf. Bei solch einer Ausführungsform weist dann oftmals auch der metallische Anteil der Gradientenschicht einen Gradienten derart auf, dass der metallische Anteil an der Schichtoberfläche am höchsten ist, der dann in die Schichttiefe kontinuierlich bis auf Null abnimmt.

Solch eine Schicht kann beispielsweise als Haftvermittler zwischen einem polymeren Substratmaterial und einer Metallschicht verwendet werden. Soll beispielsweise eine Kupferschicht auf einem Polymide-Material abgeschieden werden, so kann beispielsweise das hintere Magnetron mit einem Kupfertarget bestückt werden und auf diese Weise eine Haftschicht auf dem Substrat abgeschieden werden, welche eine obere Teilschicht aus Kupfer aufweist, die dann noch mit anderen Abscheideverfahren verstärkt werden kann.

Alternativ kann bei Anordnung des Monomer-Einlasses hinter den zwei Magnetrons, wenn dann die in Bewegungsrichtung des Substrates vorderen Bereiche des ersten Targets nicht vollständig mit Oxidpartikeln und/oder Monomerbestandteilen bedeckt sind, auf diese Weise auch eine an die Substratoberfläche angrenzende metallische Teilschicht abgeschieden werden.

### Ausführungsbeispiel

Die Erfindung wird nachfolgend anhand eines bevorzugten Ausführungsbeispiels näher erläutert. Die Fig. zeigen:
- Fig. 1: eine schematische Darstellung einer erfindungsgemäßen Vorrichtung zum Abscheiden einer Gradientenschicht;
- Fig. 2: eine graphische Darstellung der Konzentration der Schichtelemente Silizium, Sauerstoff, Kohlenstoff und Wasserstoff in at.%, aufgetragen über die Analysetiefe.

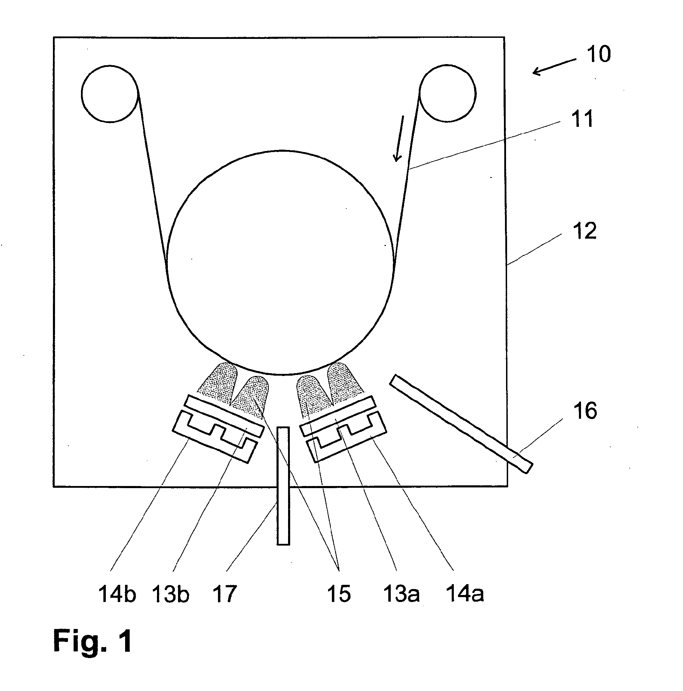

In Fig. 1 ist schematisch eine Vorrichtung 10 dargestellt, mittels der eine transparente und 120 nm dicke Schicht mit einem Kohlenstoffgradienten im Schichtdickenverlauf auf einem Substrat 11 in einem Rolle-zu-Rolle-Verfahren abgeschieden werden soll. Dabei soll die Schicht in Substratnähe den größten Kohlenstoffanteil aufweisen, der sich zur Schichtoberfläche hin verringern soll.

Das als 75 µm dicke PET-Folie ausgebildete Substrat 11 wird innerhalb einer Vakuumkammer 12 mit einer Bandgeschwindigkeit von 0,16 m/min durch eine Beschichtungszone geführt. Innerhalb der Beschichtungszone bilden zwei mit jeweils einem Al-Target 13a, 13b bestückte Planarmagnetrons 14a, 14b ein Plasma 15 zwischen den Magnetrons 14a, 14b und dem Substrat 11 aus. Beide Planarmagnetrons 14a; 14b sind in Bewegungsrichtung des Substrates 11 hintereinander angeordnet, quer zur Bewegungsrichtung des Substrates 11 ausgerichtet und werden mit einer Leistung von jeweils 1 KW gespeist.

In Bewegungsrichtung (durch den Pfeil am Substrat dargestellt) des Substrates 11 vor dem Magnetron 14a ist in unmittelbarer Nähe des Magnetrons 14a ein Einlass 16 angeordnet, durch den das Monomer TEOS mit 18 sccm in die Vakuumkammer 12 eingelassen wird. Dabei ist der Einlass 16 mit einem Maß von 20 mm vom Magnetron 14a beabstandet. Zwischen dem Magnetron 14a und dem Magnetron 14b befindet sich noch ein zweiter Einlass 17, durch den das Prozessgas Sauerstoff mit 200 sccm in die Vakuumkammer 12 eingelassen wird.

Aufgrund des bezüglich der Magnetrons asymmetrischen Einlasses des Monomers TEOS durch den Einlass 16, bildet sich im Bereich zwischen den Magnetrons 14a, 14b und dem Substrat 11 in Bewegungsrichtung des Substrates 11 ein Konzentrationsgradient des Monomers aus. Dabei ist der Konzentrationsgehalt des Monomers unmittelbar nach Verlassen des Einlasses 16 am höchsten und nimmt mit zunehmendem Abstand von Einlass 16 kontinuierlich ab. Daher nimmt auch die Anzahl der vom Plasma 15 aktivierten und für eine chemische Schichtabscheidung zur Verfügung stehenden Monomerpartikel in Bewegungsrichtung des Substrates 11 ab. Je weiter das Substrat 11 die Beschichtungszone durchquert, umso geringer ist daher auch der Schichtzuwachs resultierend aus chemischer Schichtabscheidung.

Der in der Vakuumkammer 12 befindliche Sauerstoff bewirkt, dass sich Oxidpartikel an der Oberfläche der Targets 13a, 13b bilden. Des Weiteren lagern sich an den Oberflächen der Targets 13a, 13b auch Monomerbestandteile ab. Die oben beschriebenen Parameter wie Leistung der Magnetrons 14a, 14b und die Mengen von in die Vakuumkammer 12 eingelassenem Monomer und Sauerstoff sind derart aufeinander abgestimmt, dass die Oberfläche der Targets 13a, 13b während des Abscheidevorgangs ständig mit Oxidpartikeln und Monomerbestandteilen bedeckt sind. Ein Sputterabtrag von metallischen Aluminiumpartikeln findet daher nicht statt. Bei einer Analyse der abgeschiedenen Schicht mittels einer ERDA-(Elastic Recoil Detection Analysis)-Messung konnte daher auch keine Teilschicht mit metallischem Aluminiumanteil ermittelt werden.

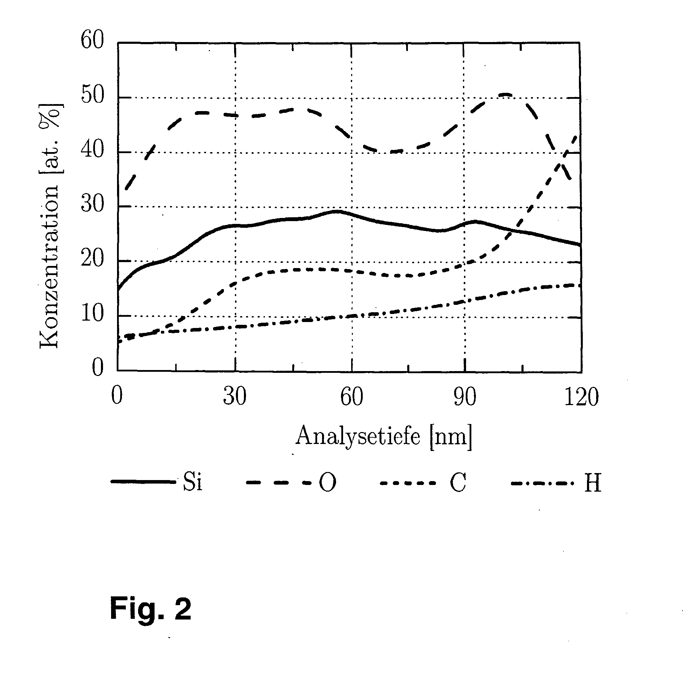

In Fig. 2 sind die aus der ERDA-Messung ermittelten Schichtbestandteile Silizium, Sauerstoff, Kohlenstoff und Wasserstoff in Atom-Prozent über die Schichtdicke graphisch dargestellt. Dabei ist die Schichtdicke in Form der Analysetiefe angegeben, wobei der Wert 0 nm folglich der Schichtoberfläche entspricht und wobei sich die Analysetiefe von 120 nm dementsprechend unmittelbar über der Substratoberfläche befindet. Aus Fig. 2 ist ersichtlich, dass die Elemente Kohlenstoff und Wasserstoff, welche nach dem Aufspalten des Monomers durch das Plasma auch Verbindungen wie Kohlendioxid oder Wasserdampf (also Verbindungen mit einem geringen Sticking-Koeffizienten) eingehen, einen Gradienten im Schichtdickenverlauf ausbilden. Dabei weist die Schicht in Substratnähe den höchsten Anteil dieser Elemente auf, der dann mit zunehmender Schichtdicke zur Schichtoberfläche hin immer geringer wird.

Bei einem zweiten Beschichtungsvorgang mit der in Fig. 1 schematisch dargestellten Vorrichtung 10 wird der Zufluss des Prozessgases Sauerstoff durch den Einlass 17 auf 3 sccm und der Zufluss des Monomers durch den Einlass 16 auf 7 sccm reduziert, so dass die Oberfläche des Targets 13b - und dort insbesondere der in Bewegungsrichtung des Substrates 11 hintere Oberflächenbereich des Targets 13b - während des Beschichtungsvorgangs nicht mehr vollständig mit Oxidpartikeln und Monomerbestandteilen bedeckt ist. Daraus resultiert, dass während des Beschichtens metallische Aluminiumpartikel aus diesem Targetoberflächenbereich abgestäubt und auf dem Substrat 11 abgeschieden werden. Neben dem gewünschten Kohlenstoff-Gradienten weist die mit dem zweiten Beschichtungsvorgang abgeschiedene Schicht zusätzlich im oberflächennahen Schichtdickenbereich einen metallischen Aluminiumanteil auf, der an der Oberfläche am stärksten ausgeprägt ist und mit zunehmender Schichttiefe Richtung Substrat kontinuierlich bis auf Null zurückgeht.

## Patentansprüche

1. Vorrichtung zum Abscheiden einer Schicht auf einem innerhalb einer Vakuumkammer (12) bewegten Substrat (11), wobei zumindest ein Schichtelement einen Gradienten im Schichtdickenverlauf aufweist, umfassend einen ersten Einlass (16), durch welchen das Schichtelement als Bestandteil eines Monomeres in die Vakuumkammer (12) einlassbar ist, und mindestens ein Magnetron (14a) zum Erzeugen eines Plasmas (15), welches das Monomer aktiviert und eine chemische Schichtabscheidung auf dem Substrat (11) bewirkt, wobei der erste Einlass (16) in Bewegungsrichtung des Substrates (11) betrachtet vor oder nach dem Magnetron (14a) angeordnet ist.

2. Vorrichtung nach Anspruch 1, **dadurch gekennzeichnet, dass** der erste Einlass (16) mit einem Maß von 5 mm bis 100 mm vom Magnetron (14a) beabstandet ist.

3. Vorrichtung nach einem der vorhergehenden Ansprüche, **dadurch gekennzeichnet, dass** das Magnetron (14a) als Planarmagnetron oder Rohrmagnetron ausgebildet ist, welches quer zur Bewegungsrichtung des Substrates ausgerichtet ist.

4. Vorrichtung nach einem der vorhergehenden Ansprüche, **gekennzeichnet durch** mindestens ein erstes Magnetron (14a) und ein zweites Magnetron (14b), welche derart ausgerichtet sind, dass zumindest ein Oberflächenbereich des zum ersten Magnetron (14a) gehörenden Targets (13a) und ein Oberflächenbereich des zum zweiten Magnetron (14b) gehörenden Targets (13b) in Bewegungsrichtung des Substrates (11) betrachtet hintereinander angeordnet sind und dass der erste Einlass (16) in Bewegungsrichtung des Substrates (11) betrachtet vor oder nach den beiden Oberflächenbereichen der zwei Targets (13a; 13b) angeordnet ist.

5. Vorrichtung nach Anspruch 4, **dadurch gekennzeichnet, dass** die zwei Magnetrons als Doppelmagnetron ausgebildet sind, welches ein ringförmiges Außentarget und ein ringförmiges oder scheibenförmiges Innentarget aufweist.

6. Vorrichtung nach einem der vorhergehenden Ansprüche, **dadurch gekennzeichnet, dass** mindestens ein Magnetron mit einer unipolar oder bipolar pulsenden Stromversorgungseinrichtung elektrisch verbunden ist.

7. Vorrichtung nach einem der vorhergehenden Ansprüche, **dadurch gekennzeichnet, dass** mittels eines zweiten Einlasses (17) ein Reaktivgas in die Vakuumkammer (12) einlassbar ist.

8. Vorrichtung nach einem der vorhergehenden Ansprüche, **dadurch gekennzeichnet, dass** mittels eines dritten Einlasses ein Inertgas in die Vakuumkammer einlassbar ist.

9. Verfahren zum Abscheiden einer Schicht auf einem innerhalb einer Vakuumkammer (12) bewegten Substrat (11), wobei zumindest ein Schichtelement einen Gradienten im Schichtdickenverlauf aufweist, wobei das Schichtelement als Bestandteil eines Monomers durch einen ersten Einlass (16) in die Vakuumkammer (12) eingelassen wird und mittels mindestens eines Magnetrons (14a) ein Plasma (15) erzeugt wird, welches das Monomer aktiviert und eine chemische Schichtabscheidung auf dem Substrat (11) bewirkt und wobei der erste Einlass (16) in Bewegungsrichtung des Substrates (11) betrachtet vor oder nach dem Magnetron (14a) angeordnet wird.

10. Verfahren nach Anspruch 9, **dadurch gekennzeichnet, dass** der erste Einlass (16) mit einem Maß von 5 mm bis 100 mm vom Magnetron (14a) beabstandet wird.

11. Verfahren nach einem der Ansprüche 9 bis 10, **dadurch gekennzeichnet, dass** ein Planarmagnetron (14a; 14b) oder Rohrmagnetron verwendet und quer zur Bewegungsrichtung des Substrates (11) angeordnet wird.

12. Verfahren nach einem der Ansprüche 9 bis 11, **dadurch gekennzeichnet, dass** das Magnetron (14a) mit einer unipolar oder bipolar pulsenden Stromversorgungseinrichtung elektrisch verbunden wird.

13. Verfahren nach einem der Ansprüche 9 bis 12, **dadurch gekennzeichnet, dass** mindestens ein erstes Magnetron (14a) und ein zweites Magnetron (14b) verwendet und derart ausgerichtet werden, dass zumindest ein Oberflächenbereich des zum ersten Magnetron (14a) gehörenden Targets (13a) und ein Oberflächenbereich des zum zweiten Magnetron (14b) gehörenden Targets (14b) in Bewegungsrichtung des Substrates (11) betrachtet hintereinander angeordnet sind und dass der erste Einlass (16) in Bewegungsrichtung des Substrates (11) betrachtet vor oder nach den beiden Oberflächenbereichen der zwei Targets (13a; 13b) angeordnet ist.

14. Verfahren nach einem der Ansprüche 9 bis 13, **dadurch gekennzeichnet, dass** mittels eines zweiten Einlasses (17) ein Reaktivgas in die Vakuumkammer (12) eingelassen wird.

15. Verfahren nach einem der Ansprüche 9 bis 14, **dadurch gekennzeichnet, dass** mittels eines dritten Einlasses ein Inertgas in die Vakuumkammer eingelassen wird.
